# EUROPEAN PATENT SPECIFICATION

(11) **EP 1 455 441 B1**
(45) Date of publication and mention of the grant of the patent: **08.11.2006**
(21) Application number: 04000143.0
(22) Date of filing: 07.01.2004
(51) Int. Cl.: H03D 7/14

(54) **Television tuner**
Fernsehertuner
Syntoniseur de télévision

(30) Priority: 14.01.2003 JP 2003000142 U
(43) Date of publication of application: 08.09.2004
(73) Proprietor: ALPS ELECTRIC CO., LTD., Tokyo 145-8501 (JP)
(72) Inventor: Yamamoto, Masaki c/o Alps Electrci Co., Ltd., Tokyo, 145-8501 (JP)
(74) Representative: Klunker . Schmitt-Nilson . Hirsch

(56) References cited:
- US-A- 5 379 457
- US-A- 5 563 545
- US-A1- 2002 135 045
- US-B1- 6 472 925

## Description

The present device relates to a television tuner.

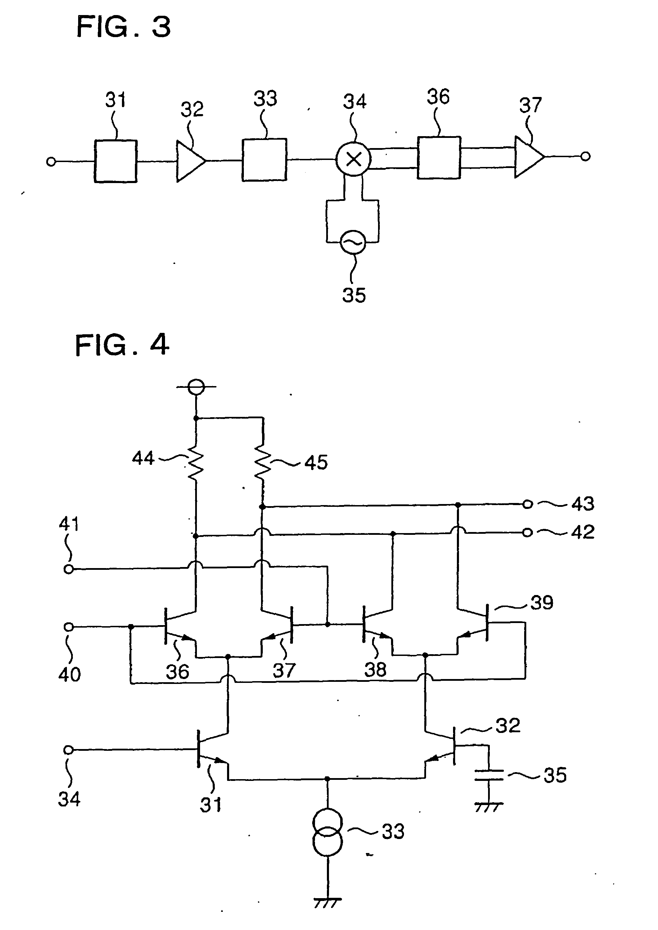

The structure of a known television tuner is shown in Fig. 3. An input tuning circuit 31 is tuned to, for example, one of VHF-high-band television signals, VHF-low-band television signals, and UHF-band television signals. The television signals tuned to one of the VHF-high, VHF-low, and the UHF bands are amplified by a high-frequency amplifier 32 and then selected by an interstage tuning circuit 33. The interstage tuning circuit 33 is also tuned to either the VHF-high-band television signals or the VHF-low-band television signals. The television signals that are supplied to a mixer circuit 34 are mixed with balanced local oscillation signals from an oscillator 35 to be converted into intermediate-frequency signals. The balanced intermediate-frequency signals output from the mixer circuit 34 pass through a balanced intermediate-frequency tuning circuit 36 to be supplied to an intermediate-frequency amplifier 37 for amplification.

The structure of the mixer circuit 34 will now be described with reference to Fig. 4.

A first transistor 31 is differentially connected to a second transistor 32; that is, both the emitter of the first transistor 31 and the emitter of the second transistor 32 are connected to a constant-current source 33. The base of the first transistor 31 is connected to an input port 34. The base of the second transistor 32 is RF-grounded through a grounded capacitor 35. The high-band or low-band television signals from the interstage tuning circuit 33 are supplied to the input terminal 34.

The collector of the first transistor 31 is connected to the emitter of a third transistor 36 and to the emitter of a fourth transistor 37. The collector of the second transistor 32 is connected to the emitter of a fifth transistor 38 and to the emitter of a sixth transistor 39. Accordingly, the third transistor 36 is differentially connected to the fourth transistor 37, and the fifth transistor 38 is differentially connected to the sixth transistor 39.

The base of the third transistor 36 that is connected to the base of the sixth transistor 39 is connected to an input port 40 for local oscillation signals. The base of the fourth transistor 37 that is connected to the base of the fifth transistor 38 is connected to an input port 41 for the local oscillation signals. The local oscillation signals are differentially input between the two input ports 40 and 41.

The collector of the third transistor 36 is connected to the collector of the fifth transistor 38. The collector of the fourth transistor 37 is connected to the collector of the sixth transistor 39. The connection point of the collector of the third transistor 36 and the collector of the fifth transistor 38 is an output port 42 through which intermediate-frequency signals are differentially output. The connection point of the collector of the fourth transistor 37 and the collector of the sixth transistor 39 is an output port 43 through which the intermediate-frequency signals are differentially output. The intermediate-frequency signals are supplied to the intermediate-frequency tuning circuit 36.

The television tuner described above generally has a problem in that the gain decreases as the frequency of the input television signals increases, and therefore, gain variation occurs within one frequency band. This is mainly because the gain in the high-frequency amplifier or the conversion gain in the mixer circuit decreases as the frequency increases due to the characteristics of the amplifying elements used. The above problem is also involved in the loss in each tuning circuit, which increases along with the increase in frequency. In either case, the gain variation occurs in a stage between the input tuning circuit and the mixer circuit.

The closest prior art constituting background of the present invention is shown in US 6 472 925. This reference discloses a balanced mixer circuit for converting a first input signal into a second signal, wherein the circuit comprises first and second transistors for amplifying the first input signal. The emitter of the first transistor is connected to the emitter of the second transistor via a gain-setting resistance. A first constant-current source is connected to the emitter of the first transistor, a second constant-current source is connected to the emitter of the second transistor. Reactance means is connected in parallel to the gain-setting resistance. The reactance of the reactance means decreases as the frequency increases.

Accordingly, an object of the present device is to vary the conversion gain of the mixer circuit to reduce the gain variation within one frequency band.

In order to solve the problems described above, the television tuner according to the present invention has the features of claim 1. In an embodiment of the invention, the capacitance of the capacitive element is set such that the reactance of the capacitive element varies from a value lower than the resistance of the gain-setting resistance to a value higher than the resistance of the gain-setting resistance within a predetermined frequency band of the television signals.

In an embodiment of the invention, the VHF-band television signals or UHF-band television signals are supplied to the mixer circuit.

In an embodiment of the invention, the reactance means is included in an integrated circuit along with the first transistor and the second transistor.

As described above, the mixer circuit includes first and second transistors for amplifying television signals, the emitter of the first transistor being connected to the emitter of the second transistor through a gain-setting resistance; a first constant-current source connected to the emitter of the first transistor; and a second constant-current source connected to the emitter of the second transistor. Reactance means is connected in parallel to the gain-setting resistance. The reactance of the reactance means decreases as the frequency increases. With this structure, the current can easily flow between the emitters of the two transistors as the frequency increases, thus reducing the negative feedback to increase the gains in the first transistor 1 and the second transistor 2. Accordingly, higher conversion gain can be achieved as a mixer. As a tuner, the gain at higher frequencies within one frequency band increases to equalize the gain variation.

Since the reactance means is a capacitive element, it is easy to equalize the gain variation.

The capacitance of the capacitive element is set such that the reactance of the capacitive element varies from a value lower than the resistance of the gain-setting resistance to a value higher than the resistance of the gain-setting resistance within a predetermined frequency band of the television signals. Accordingly, a large variation in impedance between the emitters is effective in equalizing the gain variation.

Since VHF-band television signals or UHF-band television signals are supplied to the mixer circuit, the gain variation can be equalized within the VHF band or the UHF band.

The reactance means is included in an integrated circuit along with the first transistor and the second transistor, thus simplifying the structure of the television tuner.

### Brief Description of the Drawings

Fig. 1 is a circuit diagram showing the structure of a television tuner of the present device.
Fig. 2 is a circuit diagram showing the structure of a mixer circuit used in the television tuner of the present device.
Fig. 3 is a circuit diagram showing the structure of a known television tuner.
Fig. 4 is a circuit diagram showing the structure of a mixer circuit used in the known television tuner.

### Description of the Embodiments

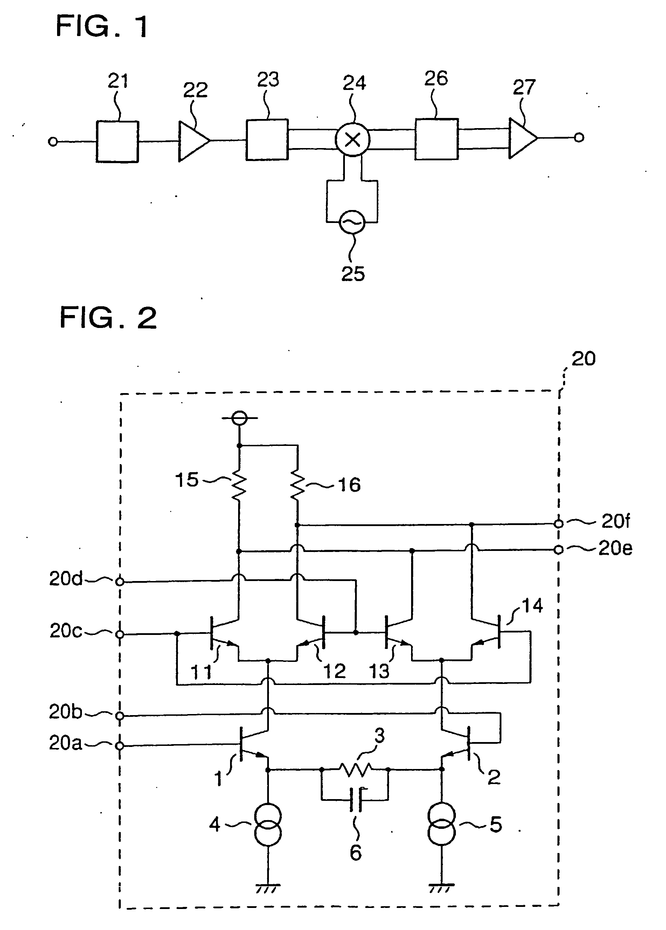

The structure of a television tuner of the present device will now be described with reference to Fig. 1. An input tuning circuit 21 is tuned to, for example, VHF-high-band television signals or VHF-low-band television signals. The VHF-high-band or VHF-low-band television signals are amplified by a high-frequency amplifier 22 and then selected by an interstage tuning circuit 23. The interstage tuning circuit 23 is also tuned to the VHF-high-band or VHF-low-band television signals. The tuned television signals are differentially input to a mixer circuit 24. The VHF-high-band or VHF-low-band television signals that are input are mixed with balanced local oscillation signals from an oscillator 25 to be converted into intermediate-frequency signals. The balanced intermediate-frequency signals output from the mixer circuit 24 pass through a balanced intermediate-frequency tuning circuit 26 to be supplied to an intermediate-frequency amplifier 27 for amplification.

The structure of the mixer circuit 24 will now be described with reference to Fig. 2. The mixer circuit 24 is included in an integrated circuit 20, as shown in Fig. 2. The emitter of a first transistor 1 is connected to the emitter of a second transistor 2 through a gain-setting resistance 3 in the integrated circuit 20. The emitter of the first transistor 1 is connected to a first constant-current source 4, and the emitter of the second transistor 2 is connected to a second constant-current source 5. Reactance means 6, which is a capacitive element or the like, is connected in parallel to the gain-setting resistance 3. The reactance value of the reactance means 6 decreases as the frequency increases.

The base of the first transistor 1 is connected to a first input terminal 20a in the integrated circuit 20. The base of the second transistor 2 is connected to a second input terminal 20b in the integrated circuit 20. For example, the VHF-high-band or VHF-low-band television signals are switched to be differentially input between the first input terminal 20a and the second input terminal 20b. One input terminal, for example, the second input terminal 20b may be RF-grounded for supplying the television signals only to the first input terminal 20a.

The collector of the first transistor 1 is connected to a third transistor 11 and to a fourth transistor 12, which are differentially connected to each other. That is, the emitter of the third transistor 11 and the emitter of the fourth transistor 12 are connected to the collector of the first transistor 1. The collector of the second transistor 2 is connected to a fifth transistor 13 and to a sixth transistor 14, which are differentially connected to each other. That is, the emitter of the fifth transistor 13 and the emitter of the sixth transistor 14 are connected to the collector of the second transistor 2. The third to sixth transistors 11 to 14 are also included in the integrated circuit 20.

The base of the third transistor 11 that is connected to the base of the sixth transistor 14 is connected to a third input terminal 20c in the integrated circuit 20. The base of the fourth transistor 12 that is connected to the base of the fifth transistor 13 is connected to a fourth input terminal 20d in the integrated circuit 20. The local oscillation signals from the oscillator 25 are differentially input between the third input terminal 20c and the fourth input terminal 20d.

The collector of the third transistor 11 is connected to the collector of the fifth transistor 13. The connection point of the collectors of the third transistor 11 and the fifth transistor 13 is a first output terminal 20e in the integrated circuit 20. The collector of the fourth transistor 12 is connected to the collector of the sixth transistor 14. The connection point of the collectors of the fourth transistor 12 and the sixth transistor 14 is a second output terminal 20f in the integrated circuit 20. A supply voltage is supplied to the collectors of the third transistor 11 and the fifth transistor 13 through a feed resistance 15. A supply voltage is supplied to the collectors of the fourth transistor 12 and the sixth transistor 14 through a feed resistance 16. The connection described above realizes a double-balanced mixer circuit.

The intermediate-frequency signals that undergo frequency conversion are differentially output from between the first output terminal 20e and the second output terminal 20f. The output intermediate-frequency signals are supplied to the intermediate-frequency tuning circuit 26.

With the structure described above, one of the emitter currents flowing through the first transistor 1 and the second transistor 2 increases as the other emitter current decreases in accordance with the phase of the input television signals. In contrast, the currents flowing through the first constant-current source 4 and the second constant-current source 5 are constant (and identical). Hence, the variation between the emitter current flowing through the first transistor 1 and the emitter current flowing through the second transistor 2 is supplied from one of the first transistor 1 and the second transistor 2 to the other through the gain-setting resistance 3 and the reactance means 6.

The current value supplied here is determined by (the absolute value of) the combined impedance of the gain-setting resistance 3 and the reactance means 6, which are connected in parallel to each other. Since the combined impedance decreases as the frequency increases, the current can easily flow as the frequency increases, thus reducing the negative feedback to increase the gains in the first transistor 1 and the second transistor 2. Accordingly, higher conversion gain can be achieved as a mixer.

Hence, as a tuner, the gain at higher frequencies within one frequency band increases to equalize the gain variation.

It is effective in equalizing the gain variation to set the capacitance of the capacitive element serving as the capacitive means 6 such that the reactance of the capacitive element varies from a value lower than the resistance of the gain-setting resistance 3 to a value higher than the resistance of the gain-setting resistance 3 within a predetermined frequency band of the television signals.

For example, if the gain-setting resistance 3 has a resistance of 80 W, it is desirable to select a capacitance of the capacitive element such that the reactance of the capacitive element varies from a value lower than 80 W to a value higher than 80 W between the upper limit and the lower limit of a predetermined frequency band.

### Reference Numerals

1: first transistor
2: second transistor
3: gain-setting resistance
4: first constant-current source
5: second constant-current source
6: reactance means
11: third transistor
12: fourth transistor
13: fifth transistor
14: sixth transistor
15, 16: feed resistance
20: integrated circuit
20a: first input terminal
20b: second input terminal
20c: third input terminal
20d: fourth input terminal
20e: first output terminal
20f: second output terminal
21: input tuning circuit
22: high-frequency amplifier
23: interstage tuning circuit
24: mixer circuit
25: oscillator
26: intermediate-frequency tuning circuit
27: intermediate-frequency amplifier

## Claims

1. A television tuner comprising a balanced mixer circuit (24) for converting television signals into intermediate-frequency signals, the mixer circuit (24) including first (1) and second (2) transistors for amplifying the television signals, the emitter of the first transistor (1) being connected to the emitter of the second transistor (2) through a gain-setting resistance (3); a first constant-current source (4) connected to the emitter of the first transistor (1); and a second constant-current source (5) connected to the emitter of the second transistor (2), wherein reactance means (6) which is formed only by a capacitive element is connected in parallel to the gain-setting resistance (3) so that the capacitive element reduces the gain variation of the mixer circuit (24) within a predetermined frequency bound of the television signals.

2. A television tuner according to Claim 1, wherein the capacitance of the capacitive element is set such that the reactance of the capacitive element varies from a value lower than the resistance of the gain-setting resistance (3) to a value higher than the resistance of the gain-setting resistance (3) within said predetermined frequency band of the television signals.

3. A television tuner according to any of Claims 1 or 2, wherein VHF-band television signals or UHF-band television signals are supplied to the mixer circuit (24).

4. A television tuner according to any of Claims 1 to 3, wherein the reactance means (6) is included in an integrated circuit along with the first transistor (1) and the second transistor (2).

## Patentansprüche

1. Fernsehtuner, umfassend einen symmetrischen Mischer (24) zum Umwandeln von Fernsehsignalen in Zwischenfrequenzsignale, wobei der Mischer (24) einen ersten (1) und einen zweiten (2) Transistor enthält, um die Fernsehsignale zu verstärken, der Emitter des ersten Transistors (1) an den Emitter des zweiten Transistors (2) über einen Verstärkungseinstellwiderstand (3) angeschlossen ist, eine erste Konstantstromquelle (4), die an den Emitter des ersten Transistors (1) angeschlossen ist, und eine zweite Konstantstromquelle (5), die an den Emitter des zweiten Transistors (2) angeschlossen ist, wobei parallel zu dem Verstärkungseinstellwiderstand (3) eine lediglich durch ein kapazitives Element gebildete Reaktanzeinrichtung (6) geschaltet ist, so dass das Kapazitätselement die Verstärkungsschwankung des Mischers (24) innerhalb eines vorbestimmten Frequenzbands der Fernsehsignale verringert.

2. Fernsehtuner nach Anspruch 1, bei dem die Kapazität des kapazitiven Elements derart eingestellt ist, dass die Reaktanz des kapazitiven Elements von einem Wert unterhalb des Widerstandswerts des Verstärkungseinstellwiderstands (3) bis zu einem Wert oberhalb des Widerstandswerts des Verstärkungseinstellwiderstands (3) innerhalb des vorbestimmten Frequenzbands der Fernsehsignale variiert.

3. Fernsehtuner nach Anspruch 1 oder 2, bei dem VHF-Band-Fernsehsignale oder UHF-Band-Fernsehsignale an den Mischer (24) gegeben werden.

4. Fernsehtuner nach einem der Ansprüche 1 bis 3, bei dem die Reaktanzeinrichtung (6) in einer integrierten Schaltung zusammen mit dem ersten Transistor (1) und dem zweiten Transistor (2) enthalten ist.

## Revendications

1. Syntoniseur de télévision comprenant un circuit mélangeur symétrique (24) pour convertir des signaux de télévision en signaux de fréquence intermédiaire, le circuit mélangeur (24) comprenant des premier (1) et second (2) transistors pour amplifier les signaux de télévision, l'émetteur du premier transistor (1) étant connecté à l'émetteur du second transistor (2) via une résistance de réglage de gain (3), une première source de courant constant (4) connectée à l'émetteur du premier transistor (1), et une seconde source de courant constant (5) connectée à l'émetteur du second transistor (2), un moyen de réactance (6), qui est formé seulement par un élément capacitif, est connecté en parallèle à la résistance de réglage de gain (3) de telle manière que l'élément capacitif réduit la variation de gain du circuit mélangeur (24) à l'intérieur d'une bande de fréquences prédéterminée des signaux de télévision.

2. Syntoniseur de télévision selon la revendication 1, dans lequel la capacité de l'élément capacitif est choisie de telle manière que la réactance de l'élément capacitif varie d'une valeur inférieure à l'impédance de la résistance de réglage de gain (3) à une valeur supérieure à l'impédance de la résistance de réglage de gain (3) dans ladite bande de fréquences prédéterminée des signaux de télévision.

3. Syntoniseur de télévision selon l'une quelconque des revendications 1 à 2, dans lequel des signaux de télévision de bande VHF ou des signaux de télévision de bande UHF sont fournis au circuit mélangeur (24).

4. Syntoniseur de télévision selon l'une quelconque des revendications 1 à 3, dans lequel le moyen de réactance (6) est inclus dans un circuit intégré, avec le premier transistor (1) et le second transistor (2).
